# EUROPEAN PATENT APPLICATION

(11) **EP 4 756 520 A1**
(43) Date of publication of application: **10.06.2026**
(21) Application number: 25221100.8
(22) Date of filing: 05.12.2025
(51) Int. Cl.: G02F 1/1333, G06F 1/16, G09F 9/30, G09F 15/00

(54) **DISPLAY DEVICE**

(30) Priority: 09.12.2024 KR 20240181818; 11.06.2025 KR 20250076625
(71) Applicant: LG Electronics Inc., Yeongdeungpo-gu Seoul 07336 (KR)
(72) Inventor: LEE, Juhun, Seoul (KR); LEE, Junghun, Seoul (KR)
(74) Representative: Schornack, Oliver

(57) **Abstract**

Disclosed is a display device. The display device includes a display panel that is configured to display an image on a surface thereof and is light-transmissive and a board electrically connected to the display panel. The board does not overlap the display panel in a first direction perpendicular to the surface of the display panel.

## Description

### CROSS-REFERENCE TO RELATED APPLICATION

This application claims the priority benefit of Korean Patent Application No. 10-2024-0181818, filed on December 09, 2024, and No. 10-2025-0076625, filed on June 11, 2025 in the Korean Intellectual Property Office, the disclosure of which is incorporated herein by reference.

### BACKGROUND OF THE DISCLOSURE

### Field of the disclosure

The present disclosure relates to a display device. More particularly, the present disclosure relates to a display device including a transparent display panel.

### Description of the Related Art

With the advent of the information society, various demands for display devices are increasing. Various display devices, such as liquid crystal display (LCD) devices, plasma display panel (PDP) devices, electroluminescent display (ELD) devices, vacuum fluorescent display (VFD) devices, and organic light emitting diode (OLED) devices, have recently been studied and used to meet various demands for display devices.

Thereamong, an LCD panel includes a thin-film transistor (TFT) substrate and a color substrate, which are disposed opposite each other with a liquid crystal layer interposed therebetween, and may display an image using light provided from a backlight unit. An OLED panel may display an image by depositing a self-emissive organic layer on a substrate having a transparent electrode formed thereon.

Recently, various studies have been conducted on transparent display panels that not only display images to a user but also allow the user to see through the display panel.

### SUMMARY OF THE DISCLOSURE

An object of the present disclosure is to solve the above and other problems.

Another object of the present disclosure may be to provide a display device having improved performance.

Still another object of the present disclosure may be to provide a display device in which a transparent region of a transparent display panel is maximized.

Yet another object of the present disclosure may be to provide a compact display device.

Still yet another object of the present disclosure may be to provide a display device having improved drainage performance.

A further object of the present disclosure may be to provide a display device having enhanced structural stability.

Another further object of the present disclosure may be to provide a display device capable of minimizing damage applied to electric components.

Still another further object of the present disclosure may be to provide an efficient arrangement structure of electric components.

In accordance with one aspect of the present disclosure for accomplishing the above or other objectives, a display device may include a display panel that is configured to display an image on a surface thereof and is light-transmissive and a board electrically connected to the display panel, wherein the board may not overlap the display panel in a first direction perpendicular to the surface of the display panel.

### BRIEF DESCRIPTION OF THE DRAWINGS

The above and other objects, features, and other advantages of the present disclosure will be more clearly understood from the following detailed description taken in conjunction with the accompanying drawings, in which:

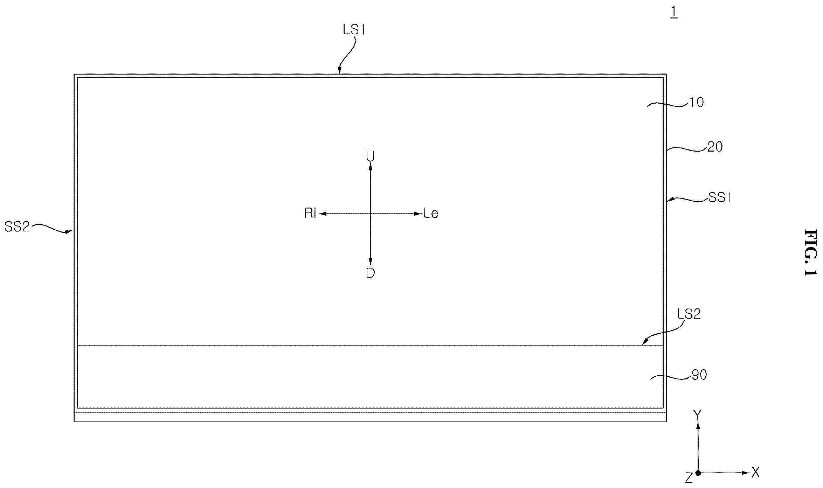

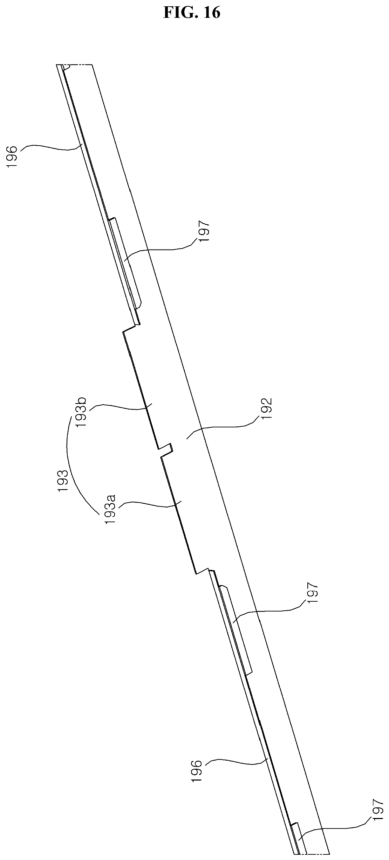

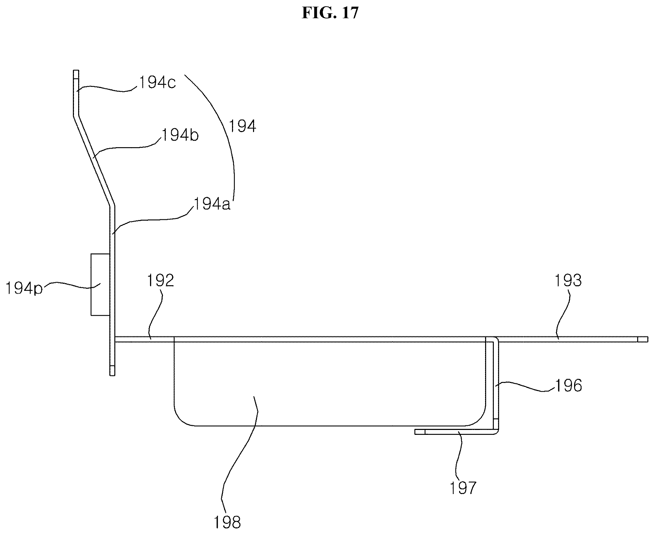

FIGs. 1 to 34 are views showing examples of a display device according to embodiments of the present disclosure.

### DETAILED DESCRIPTION

Hereinafter, the embodiments disclosed in the present specification will be described in detail with reference to the accompanying drawings, and the same or similar elements are denoted by the same reference numerals even though they are depicted in different drawings, and redundant descriptions thereof will be omitted.

In the following description, with respect to constituent elements used in the following description, the suffixes "module" and "unit" are used only in consideration of facilitation of description, and do not have mutually distinguished meanings or functions.

In the following description of the embodiments disclosed in the present specification, a detailed description of known functions and configurations incorporated herein will be omitted when the same may make the subject matter of the embodiments disclosed in the present specification rather unclear. In addition, the accompanying drawings are provided only for a better understanding of the embodiments disclosed in the present specification and are not intended to limit the technical ideas disclosed in the present specification. Therefore, it should be understood that the accompanying drawings include all modifications, equivalents, and substitutions within the scope and sprit of the present disclosure.

It will be understood that although the terms "first," "second," etc., may be used herein to describe various components, these components should not be limited by these terms. These terms are only used to distinguish one component from another component.

It will be understood that when a component is referred to as being "coupled to," "fixed to," "mounted to," "connected to," or "liked to" another component, intervening components may be present. On the other hand, when a component is referred to as being "directly coupled to," "directly fixed to," "directly mounted to," "directly connected to," or "directly liked to" another component, there are no intervening components present.

As used herein, the singular forms are intended to include the plural forms as well, unless the context clearly indicates otherwise.

It will be further understood that the terms "comprises," "comprising," "includes," and/or "including," when used herein, specify the presence of stated features, integers, steps, operations, elements, components, or combinations thereof, but do not preclude the presence or addition of one or more other features, integers, steps, operations, elements, components, or combinations thereof.

In the embodiments illustrated in the drawings, representations of directions, such as up (U), down (D), left (Le), right (Ri), front (F), and rear (R), are merely for convenience of explanation, and are not intended to limit the technical features disclosed in this specification.

Referring to FIG. 1, a display device 1 may include a display 10, a side frame 20, and a housing 90. The display 10 may display an image. The side frame 20 may extend along a periphery of the display 10. The housing 90 may be located below the display 10 and the side frame 20. Alternatively, the housing 90 may be located above, on the left side of, or on the right side of the display 10 and the side frame 20.

The display 10 may include a first long side LS1, a second long side LS2 opposite the first long side LS1, a first short side SS1 adjacent to the first and second long sides LS1 and LS2, and a second short side SS2 opposite the first short side SS1.

For convenience of explanation, the lengths of the first and second long sides LS1 and LS2 are shown and described as being greater than the lengths of the first and second short sides SS1 and SS2. However, the lengths of the first and second long sides LS1 and LS2 may be set to be approximately equal to the lengths of the first and second short sides SS1 and SS2.

A direction parallel to the long sides LS1 and LS2 of the display 10 may be referred to as a leftward-rightward direction. A direction parallel to the short sides SS1 and SS2 of the display 10 may be referred to as an upward-downward direction. A direction perpendicular to the long sides LS1 and LS2 and the short sides SS1 and SS2 of the display 10 may be referred to as a forward-backward direction.

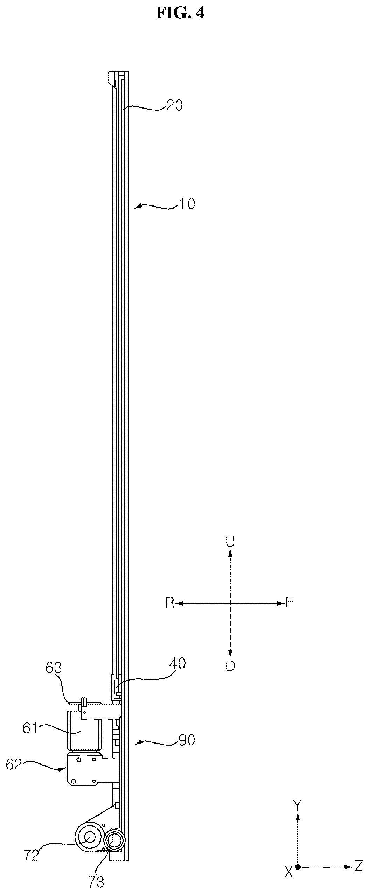

A side of the display 10 on which an image is displayed may be referred to as a front side F or z (see FIG. 4), and a side opposite the front side may be referred to as a rear side R or -z (see FIG. 4). The first short side SS1 may be referred to as a left side Le or x. The second short side SS2 may be referred to as a right side Ri or -x. The first long side LS1 may be referred to as an upper side U or y. The second long side LS2 may be referred to as a lower side D or -y.

Hereinafter, a display panel using an organic light emitting diode (OLED) will be described as an example. However, the display panel applicable to the present disclosure is not limited thereto.

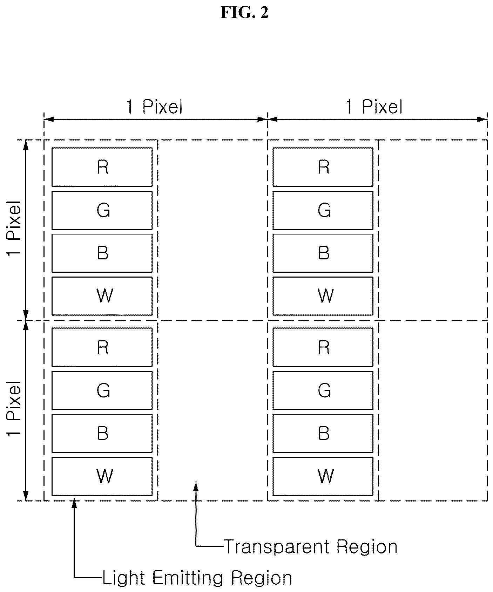

Referring to FIG. 2, a pixel may include a light emitting region and a transparent region. In the light emitting region, subpixels of red, green, blue, and white (RGBW) may be disposed in a vertical direction, and the transparent region having no subpixel may be disposed adjacent to the light emitting region.

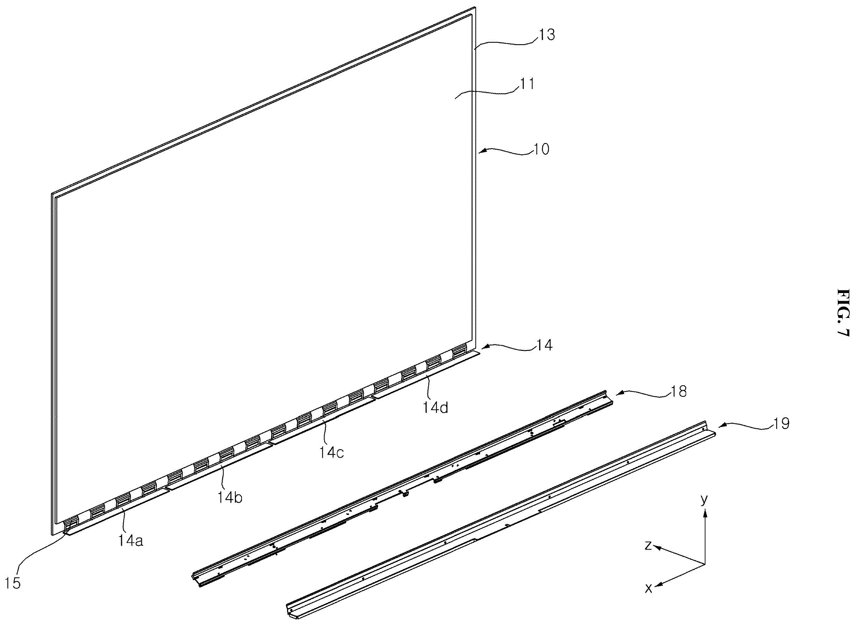

Accordingly, a display panel 11 (see FIG. 7) including a plurality of pixels may not only display an image but also transmit light. The display panel 11 (see FIG. 7) may be referred to as a transparent display panel or a transparent OLED panel.

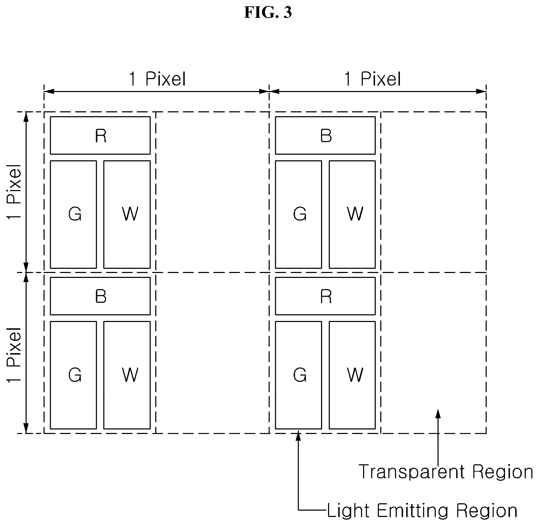

Referring to FIG. 3, a pixel may include a light emitting region and a transparent region. In the light emitting region, subpixels of red, green, and white (RGW) or blue, green, and white (BGW) may be disposed adjacent to each other, and the transparent region having no subpixel may be disposed adjacent to the light emitting region.

Accordingly, a display panel 11 (see FIG. 7) including a plurality of pixels may not only display an image but also transmit light. The display panel 11 (see FIG. 7) may be referred to as a transparent display panel or a transparent OLED panel.

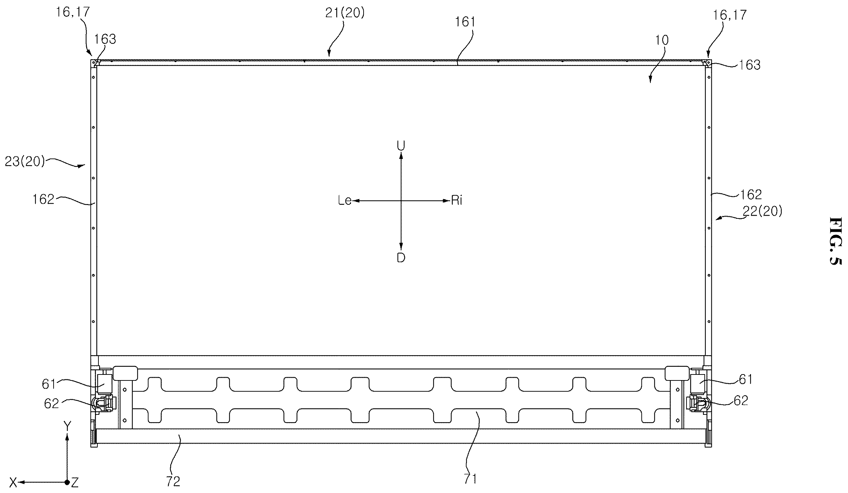

Referring to FIGs. 4 and 5, the display 10 may be coupled to the side frame 20. A housing frame 71 may be coupled or fixed to the side frame 20. The housing frame 71 may cover a rear surface of the display 10. The housing frame 71 may be located at a rear side of the display 10. The housing frame 71 may be referred to as a rear frame 71, a rear plate 71, or a rear base 71. The housing frame 71 may have a length corresponding to the lengths of the long sides LS1 and LS2 (see FIG. 1) of the display 10. The housing frame 71 may have a width that is less than the lengths of the short sides of the display 10.

A plurality of motors 61 may be provided. The plurality of motors 61 may be disposed at a rear side of the display 10 so as to be respectively adjacent to the left and right sides of the display 10. A pair of motors 61 may be provided to supply dual driving power. A plurality of gearboxes 62 may be provided corresponding to the plurality of motors 61. Each of the plurality of gearboxes 62 may be connected to a corresponding one of the plurality of motors 61. A pair of gearboxes 62 may be provided to transmit the dual driving power supplied by the pair of motors 61. The motors 61 and/or the gearboxes 62 may be coupled or fixed to the rear surface of the housing frame 71. The motors 61 and/or the gearboxes 62 may not be exposed toward a front side of the display device 1 by the housing frame 71. A bar 40 may move upward and downward while sliding in the side frame 20.

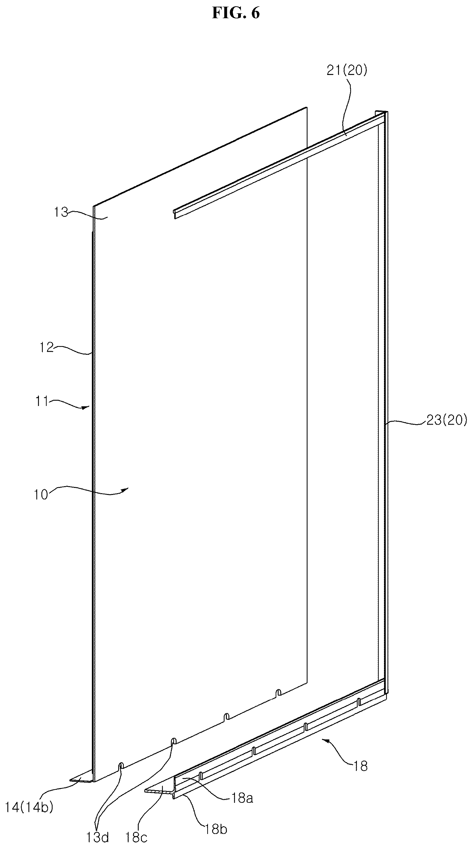

Referring to FIG. 6 together with FIG. 5, the display 10 may be coupled to the side frame 20. A lower frame 18 may be coupled or fixed to the side frame 20 and may support the display 10 at a lower side of the display 10. The side frame 20 may include a first part 21, a second part 22, and a third part 23.

The first part 21 may be coupled to an upper side of the display 10, the second part 22 may be coupled to a right side of the display 10, and the third part 23 may be coupled to a left side of the display 10. The lower frame 18 may be coupled or fixed to the second part 22 and/or the third part 23 of the side frame 20.

Vertical fixing members 162 may be respectively coupled to the second part 22 and the third part 23, and a horizontal fixing member 161 may be coupled to the first part 21. Corner fixing members 16 and pulleys 17 may be coupled to the vertical fixing members 162 and/or to the horizontal fixing member 161 at upper corners.

Referring to FIG. 7, the display panel 11 may divide an image into a plurality of pixels and may output the image by adjusting color, brightness, and saturation for each pixel. The display panel 11 may be divided into an active area (AA) in which an image is displayed and a de-active area (DA) in which an image is not displayed. The display panel 11 may emit light corresponding to a color of red (R), green (G), or blue (B) in response to a control signal.

A board 14 may be adjacent to a lower side of the display panel 11. The board 14 may extend along the lower side of the display panel 11. The board 14 may be electrically connected to the display panel 11 via a connection film 15. The board 14 may be electrically connected to a timing controller board (T-CON board) via a cable (not shown) such as a flexible flat cable (FFC).

The board 14 may be provided in plural. Each of the boards 14 may be electrically connected to the lower side of the display panel 11. The boards 14 may be arranged along a lower end of the display panel 11. For example, the boards 14 may include first to fourth boards 14a, 14b, 14c, and 14d arranged along the lower side of the display panel 11.

The board 14 may include a source printed circuit board (source PCB). The connection film 15 may include a chip on film (COF) 15.

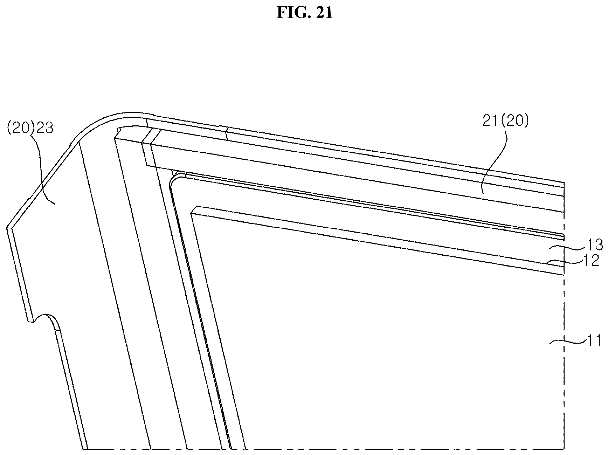

A transparent panel 13 may be located in front of the display panel 11. The transparent panel 13 may include glass made of a transparent material. An adhesive film 12 (see FIG. 21) may be located between the display panel 11 and the transparent panel 13 and may be coupled to the display panel 11 and the transparent panel 13. The adhesive film 12 (see FIG. 21) may include an optically clear adhesive (OCA) film. The transparent panel 13 may be referred to as a front panel.

An assembly of the display panel 11, the adhesive film 12 (see FIG. 21), and the transparent panel 13 may be referred to as the display 10.

The display device 1 may further include a lower frame 18 configured to support the board 14. The lower frame 18 may be elongated along the long side of the display 10. For example, the lower frame 18 may be elongated along the lower side of the display panel 11. The lower frame 18 may be adjacent to the lower side of the display panel 11. The lower frame 18 may be disposed under the board 14. The board 14 may be disposed on the lower frame 18.

The display device 1 may further include a board cover 19 configured to cover the board 14. The board cover 19 may be elongated along the long side of the display 10. For example, the board cover 19 may be elongated along the lower side of the display panel 11. The board cover 19 may be disposed on the board 14. The board 14 may be disposed between the board cover 19 and the lower frame 18.

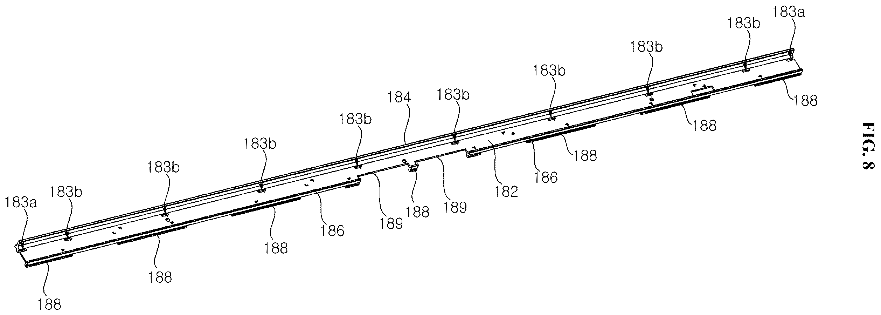

Referring to FIGs. 7 and 8, the lower frame 18 may include a lower plate 182 configured to support the board 14 and a guide wall 184 extending upward from one end of the lower plate 182. The lower frame 18 may further include a holder 186 extending from the other end of the lower plate 182.

The lower plate 182 may be elongated along the long side of the display 10. For example, the lower plate 182 may be elongated in the leftward-rightward direction along the lower side of the display 10. The lower plate 182 may have a rectangular shape when viewed in plan.

The lower plate 182 may include a recess 189 cut out from an edge thereof. The recess 189 may be located at the other end of the lower plate 182. The recess 189 may be recessed in a portion of the edge. The recess 189 may be adjacent to a center of the lower plate 182 in the longitudinal direction. For example, the recess 189 may correspond to a portion cut out in a U-shape in a central portion of the edge corresponding to the other end of the lower plate 182.

The recess 189 may be provided in plural. A pair of recesses 189 may be adjacent to the central portion of the lower plate 182. For example, when viewed in plan, the pair of recesses 189 may be symmetrically disposed with respect to the center of the lower plate 182 in the longitudinal direction.

The lower plate 182 may include at least one drainage hole 183b. The drainage hole 183b may penetrate the lower plate 182. For example, the drainage hole 183b may penetrate an upper surface and a lower surface of the lower plate 182. The drainage hole 183b may be adjacent to a front end of the lower plate 182. The drainage hole 183b may be elongated in the longitudinal direction of the lower plate 182.

The drainage hole 183b may be provided in plural. The plurality of drainage holes 183b may be arranged in the longitudinal direction of the lower plate 182. The plurality of drainage holes 183b may be spaced apart from each other. For example, the plurality of drainage holes 183b may be adjacent to the front end of the lower plate 182 and may be spaced apart from each other in the longitudinal direction of the lower plate 182. With this configuration, liquid on the lower frame 18 may be drained downward from the lower frame 18 through the drainage holes 183b.

Accordingly, damage to the electrical components (e.g., the board 14 and the connection film 15) caused by the liquid may be minimized.

In addition, the residence time of the liquid in a space in which the electrical components (e.g., the board 14 and the connection film 15) are disposed may be reduced.

Furthermore, the drainage performance of the display device 1 may be improved.

The lower plate 182 may include at least one open hole 183a. The open hole 183a may be formed in at least one of one end or the other end of the lower plate 182 in the longitudinal direction. For example, the open hole 183a may be formed in each of the left end and the right end of the lower plate 182. The open hole 183a may extend to one end or the other end of the lower plate 182 in the longitudinal direction. For example, the open hole 183a located at the left end of the lower plate 182 may be elongated to the left end of the lower plate 182 and may be open toward the left. In addition, the open hole 183a located at the right end of the lower plate 182 may be elongated to the right end of the lower plate 182 and may be open toward the right.

The drainage holes 183b may be arranged between a pair of open holes 183a. For example, eight drainage holes 183b may be disposed between a pair of open holes 183a located at the left and right ends of the lower plate 182. In addition, when viewed in plan, the eight drainage holes 183b may be symmetrically disposed with respect to the center of the lower plate 182 in the longitudinal direction.

The guide wall 184 may be elongated in the longitudinal direction of the lower plate 182. The guide wall 184 may extend from the lower plate 182. The guide wall 184 may be connected to one end of the lower plate 182. For example, the guide wall 184 may be connected to the front end of the lower plate 182 and may extend in the upward direction. The guide wall 184 may form an angle with the lower plate 182. For example, the guide wall 184 may correspond to a vertical wall connected to the lower plate 182.

The holder 186 may be elongated in the longitudinal direction of the lower plate 182. The holder 186 may extend from the lower plate 182. The holder 186 may be opposite the guide wall 184 with respect to the lower plate 182. The holder 186 may be connected to the other end of the lower plate 182. For example, the holder 186 may be connected to the rear end of the lower plate 182 and may extend in the upward direction. The holder 186 may form an angle with the lower plate 182.

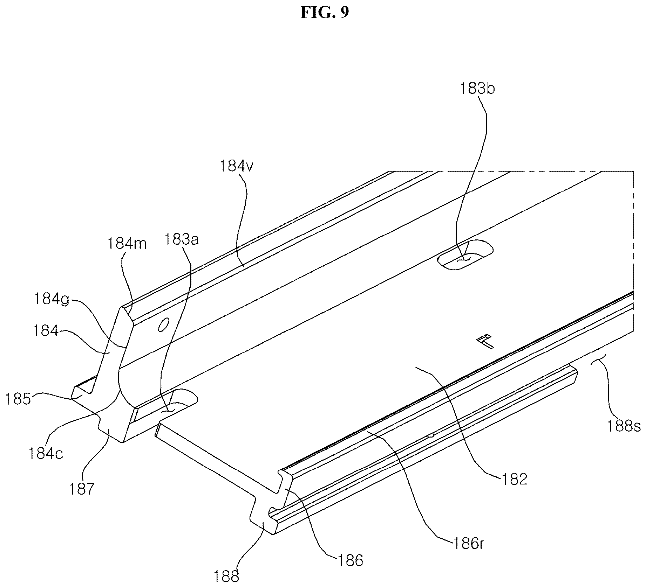

Referring to FIGs. 8 and 9, the holder 186 may have a hook shape. For example, the holder 186 may extend upward from the rear end of the lower plate 182 and may be bent forward. The holder 186 may have a hook shape facing forward. The forwardly-bent portion of the holder 186 may be referred to as a holder rib 186r. The holder rib 186r may extend forward toward the guide wall 184. The holder rib 186r may be spaced apart from the lower plate 182. A space may be defined between the holder rib 186r and the lower plate 182.

The guide wall 184 may include a guide surface 184g extending upward. The guide surface 184g may correspond to one surface of the guide wall 184. The guide surface 184g may be elongated along the long side of the display panel 11. The guide surface 184g may extend in the upward direction.

The guide wall 184 may further include a concave surface 184c between the guide surface 184g and one surface of the lower plate 182. The concave surface 184c may extend concavely from the surface of the lower plate 182. The concave surface 184c may be connected to the guide surface 184g. For example, the concave surface 184c may extend concavely from the upper surface of the lower plate 182 toward the guide surface 184g. Accordingly, the lower frame 18 may include a concave corner portion between the guide wall 184 and the lower plate 182. In addition, the guide wall 184 and the lower plate 182 may be smoothly connected to each other.

The guide wall 184 may include an inclined surface 184m extending from the guide surface 184g. The inclined surface 184m may correspond to the upper surface of the guide wall 184. The inclined surface 184m may extend from the upper end of the guide surface 184g. For example, the inclined surface 184m may extend forward and upward from the upper end of the guide surface 184g. The level of the inclined surface 184m may gradually increase in a direction away from the guide surface 184g. The level of the inclined surface 184m may gradually decrease in a direction toward the guide surface. The level may refer to a position in the upward-downward direction or the vertical direction.

The guide wall 184 may include a convex surface 184v between the guide surface 184g and the inclined surface 184m. The convex surface 184v may interconnect the guide surface 184g and the inclined surface 184m. Accordingly, the lower frame 18 may include a convex corner between the guide surface 184g and the inclined surface 184m. In addition, the guide surface 184g and the inclined surface 184m may be smoothly connected to each other.

The lower frame 18 may further include a support rib 185 extending from the guide wall 184. The support rib 185 may extend forward from the lower end of the guide wall 184. The support rib 185 may be elongated along the long side of the display 10. For example, the support rib 185 may be elongated along the long side of the transparent panel 13. The support rib 185 may have a flat upper surface. The upper surface of the support rib 185 and the front surface of the guide wall 184 may form an angle. For example, the upper surface of the support rib 185 and the front surface of the guide wall 184 may be perpendicular to each other.

The lower frame 18 may include a front base 187 and a rear base 188 supporting the lower plate 182. The front base 187 may be located farther forward than the rear base 188. The front base 187 and the rear base 188 may be spaced apart from each other in the width direction of the lower plate 182. For example, the front base 187 and the rear base 188 may be spaced apart from each other in the forward-backward direction to support the lower plate 182. The lower end of the front base 187 and the lower end of the rear base 188 may be located substantially at the same level. Accordingly, the front base 187 and the rear base 188 may support the lower plate 182 in a horizontal orientation.

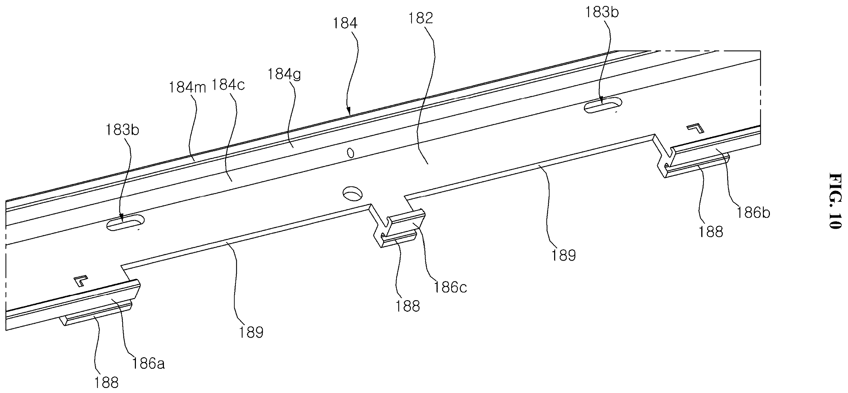

Referring to FIGs. 9 and 10, the holder 186 may be provided in plural. For example, the holder 186 may be divided into three holders 186 due to the recesses 189 corresponding to the cutout portions. One of the holders 186 may be located at the center of the lower frame 18 in the longitudinal direction and may be located between the recesses 189. Another one of the holders 186 may be located between one of the recesses 189 and one end of the lower frame 18 in the longitudinal direction. The remaining one of the holders 186 may be located between another one of the recesses 189 and the other end of the lower frame 18 in the longitudinal direction.

That is, the holder 186 may be divided into a plurality of holders due to the recesses 189.

The rear base 188 may be provided in plural. The rear base 188 may be divided into a plurality of rear bases 188. The rear bases 188 may be arranged in the longitudinal direction of the lower frame 18. In addition, the rear base 188 may be divided due to the recesses 189 corresponding to the cutout portions. One of the rear bases 188 may be located at the center of the lower frame 18 in the longitudinal direction and may be provided between the recesses 189. Another one of the rear bases 188 may extend from one of the recesses 189 in the longitudinal direction of the lower frame 18. Still another one of the rear bases 188 may extend from another one of the recesses 189 in the longitudinal direction of the lower frame 18.

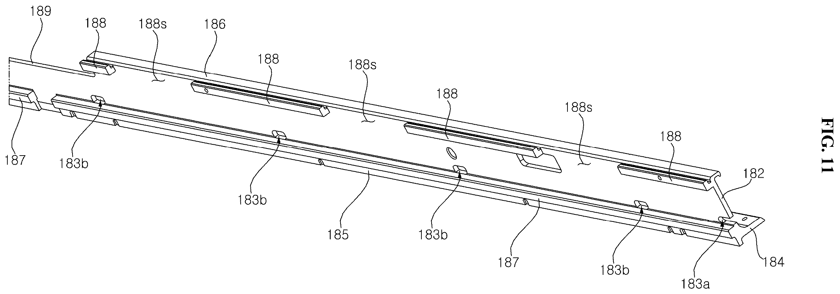

Referring to FIGs. 10 and 11, an insertion portion 188s may be defined between the rear bases 188. The insertion portion 188s may correspond to a space between the rear bases 188. The insertion portion 188s may be provided between every two adjacent ones of the rear bases 188. In this way, a plurality of insertion portions 188s may be defined. The board cover 19 may be engaged with the insertion portions 188s. The insertion portions 188s may guide the coupling position of the board cover 19.

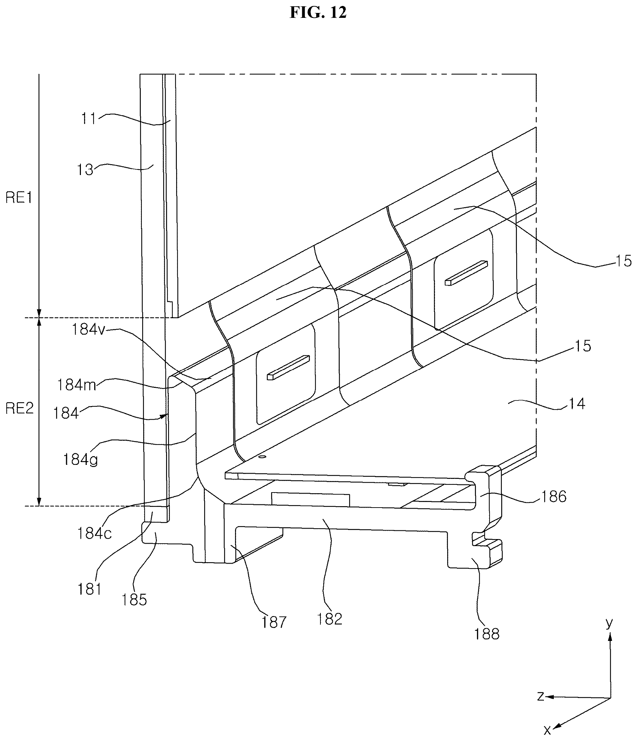

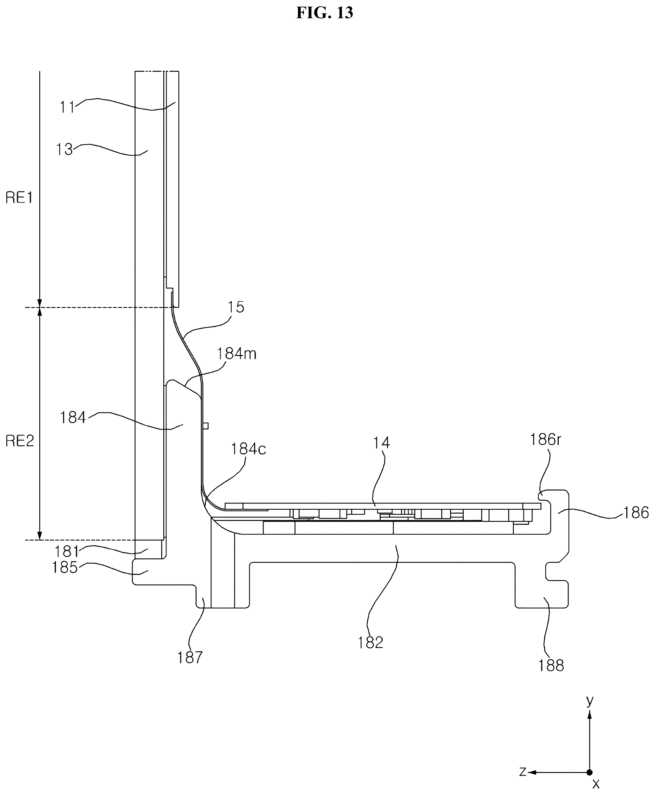

Referring to FIGs. 12 and 13, the transparent panel 13 may be disposed on the lower frame 18. The lower frame 18 may support the transparent panel 13. For example, the transparent panel 13 may be disposed on the support rib 185 of the lower frame 18, and the guide wall 184 may support the rear surface of the transparent panel 13.

A support pad 181 may be provided on the support rib 185. The support pad 181 may include a material having compressibility and elasticity. The support pad 181 may be disposed on the upper surface of the support rib 185, and the transparent panel 13 may be disposed on the support pad 181. In this way, the support pad 181 may support the transparent panel 13.

The display panel 11 may face the transparent panel 13. The display panel 11 may overlap the transparent panel 13 in the horizontal direction (e.g., the z-axis direction). The display panel 11 may be disposed on the rear surface of the transparent panel 13. The transparent panel 13 may extend below the display panel 11. For example, the lower end of the transparent panel 13 may be located below the lower end of the display panel 11. With this configuration, the transparent panel 13 may include a first region RE1 overlapping the display panel 11 and a second region RE2 not overlapping the display panel 11.

In detail, from a viewpoint on one surface of the display 10 on which an image is displayed, the display panel 11 may fully overlap the transparent panel 13. The viewpoint on one surface of the display 10 may be referred to as a planar perspective of the display 10 or a perspective in the z-axis direction. However, the transparent panel 13 may not fully overlap the display panel 11. For example, the central portion of the transparent panel 13 may overlap the display panel 11, while the lower portion of the transparent panel 13 may not overlap the display panel 11. The central portion of the transparent panel 13 may correspond to the first region RE1, and the lower portion of the transparent panel 13 may correspond to the second region RE2.

In one embodiment, the edge portion of the transparent panel 13 may not overlap the display panel 11. The edge portion of the transparent panel 13 may surround the central portion of the transparent panel 13.

From a planar perspective of the display 10, the board 14 may overlap the second region RE2 of the transparent panel 13. From a planar perspective of the display 10, the board 14 may not overlap the first region RE1 of the transparent panel 13. For example, the board 14 may be disposed behind the transparent panel 13, while the display panel 11 may not be disposed between the transparent panel 13 and the board 14. Accordingly, the board 14 may not be visible through the light-transmissive display panel 11. That is, because the board 14 does not overlap the display panel 11 from a planar perspective of the display 10, the board 14 may not be visible to a user.

Accordingly, the transparent region of the display 10 may be maximized.

The board 14 may be disposed to overlap the second region RE2 of the transparent panel 13 from a planar perspective of the display 10. The board 14 may be disposed behind the second region RE2 of the transparent panel 13. The board 14 may extend in a direction passing through one surface of the display panel 11. For example, the board 14 may be disposed behind the second region RE2 of the transparent panel 13 and may extend in the horizontal direction. That is, the board 14 may be horizontally disposed.

Accordingly, the display device 1 having a compact structure may be provided.

The board 14 may be provided on the lower frame 18. The board 14 may be disposed on one surface of the lower plate 182. The board 14 may include a surface on which chips are mounted. The surface of the board 14 may face the surface of the lower plate 182. For example, the board 14 may be disposed on the surface of the lower plate 182, and the surface of the board 14 may face the surface of the lower plate 182.

Accordingly, the board 14 may be protected from liquid entering the display device 1. For example, even when liquid approaches the board 14 from above, contact between the chips on the board 14 and the liquid may be minimized because the surface of the board 14 on which the chips are mounted faces downward.

The periphery of the board 14 may be fixed to the lower frame 18. The board 14 may be fixed to the holder 186 of the lower frame 18. For example, the rear end of the board 14 may be disposed between the holder rib 186r and the lower plate 182 of the lower frame 18.

Accordingly, the lower frame 18 may fix the board 14 in both the upward-downward direction and the forward-backward direction. For example, the holder 186 may restrict movement of the board 14 in the forward-backward direction, and the holder rib 186r may restrict movement of the board 14 in the upward-downward direction.

The connection film 15 may electrically connect the board 14 to the display panel 11. The connection film 15 may be provided in plural. The connection films 15 may be in contact with one surface of the board 14. The connection films 15 may be in contact with the lower side of the display panel 11. The connection films 15 may be disposed along the guide wall 184 from the board 14 toward the lower side of the display panel 11.

In detail, the guide wall 184 may be provided below the display panel 11. The lower side of the display panel 11 may be spaced upward from the upper end of the guide wall 184. The guide wall 184 may be located below the lower side of the display panel 11.

Accordingly, contact and interference between the guide wall 184 and the display panel 11 may be minimized, thereby reducing damage applied to the display panel 11 due to collision with the guide wall 184.

The connection film 15 may extend in a bent manner from the board 14 along the concave surface 184c of the guide wall 184. The concave surface 184c may face the connection film 15. For example, the connection film 15 may extend from the board 14 and may be bent along the concave surface 184c of the guide wall 184. The connection film 15 may include a portion bent along the concave surface 184c. The bent portion of the connection film 15 may have a smaller radius of curvature than the concave surface 184c of the guide wall 184. The connection film 15 may extend from one surface of the board 14, and a distance between the connection film 15 and the concave surface 184c may gradually decrease.

The connection film 15 may be in contact with the guide surface 184g. The guide surface 184g may face the connection film 15. The connection film 15 may be bent along the concave surface 184c and may extend along the guide surface 184g. The guide surface 184g may define a cross-sectional shape and guide placement of the connection film 15. Another portion of the connection film 15 may be disposed in a flat manner along the guide surface 184g. For example, another portion of the connection film 15 may be vertically disposed along the guide surface 184g.

The connection film 15 may extend in a bent manner from the upper end of the guide surface 184g toward the lower side of the display panel 11. The convex surface 184v of the guide wall 184 may guide the connection film 15. The connection film 15 may be in contact with the convex surface 184v of the guide wall 184. In one embodiment, the connection film 15 may not be in contact with the convex surface 184v of the guide wall 184.

As the connection film 15 extends from the upper end of the guide surface 184g, a distance between the connection film 15 and the inclined surface 184m of the guide wall 184 may gradually increase. The inclined surface 184m of the guide wall 184 may extend obliquely upward toward the transparent panel 13. The inclined surface 184m of the guide wall 184 may face the connection film 15. The connection film 15 may convexly extend from the upper end of the guide surface 184g. The connection film 15 may concavely extend in a direction toward the lower side of the display 10. For example, the remaining portion of the connection film 15 may be located between the upper end of the guide surface 184g and the lower side of the display panel 11, a lower part of the remaining portion of the connection film 15 may be convex, and an upper part of the remaining portion of the connection film 15 may be concave. An inflection point may be formed at a central part of the remaining portion of the connection film 15.

Accordingly, the guide wall 184 may guide the connection film 15 toward the display panel 11 so that the connection film 15 is not damaged.

In addition, the structural stability of the connection film 15 may be improved.

Furthermore, an efficient arrangement structure of the connection film 15 may be provided.

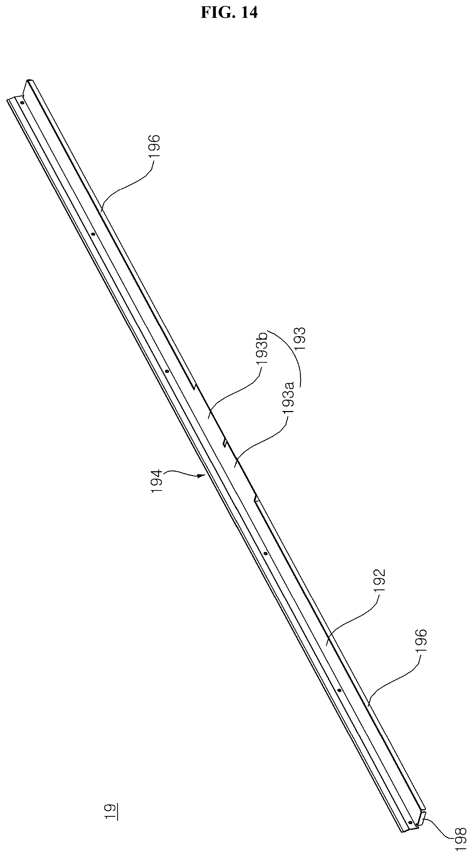

Referring to FIGs. 7 and 14, the board cover 19 may cover the board 14. The board cover 19 may be coupled to the lower frame 18. The board 14 may be disposed between the board cover 19 and the lower frame 18.

The board cover 19 may include a cover plate 192 configured to cover the board 14 and a front cover 194 corresponding to the guide wall 184 of the lower frame 18. The cover plate 192 may be elongated along the lower side of the display panel 11. The cover plate 192 may correspond to the lower plate 182. The cover plate 192 may cover the lower plate 182. The board 14 may be disposed between the cover plate 192 and the lower plate 182.

The cover plate 192 may include an extension plate 193 extending from a portion of an edge thereof. The extension plate 193 may be located at a central portion of the cover plate 192 in the longitudinal direction. For example, a pair of extension plates 193 may be located at the central portion of the cover plate 192 in the longitudinal direction and may be spaced apart from each other. The extension plate 193 may extend from the cover plate 192 in a direction intersecting the longitudinal direction of the cover plate 192. For example, the extension plate 193 may extend in the backward direction from the central portion of the cover plate 192.

The front cover 194 may extend from the cover plate 192. For example, the front cover 194 may extend upward from the front end of the cover plate 192. The front cover 194 may be bent and extend from the cover plate 192. The front cover 194 may form an angle with the cover plate 192.

The board cover 19 may include a rear cover 196 and at least one side cover 198 extending from edges of the cover plate 192. For example, the rear cover 196 may be bent and extend downward from a rear edge of the cover plate 192. In addition, the side covers 198 may be bent and extend downward from both lateral edges of the cover plate 192. Accordingly, the rear cover 196 and the side covers 198 may cover a space between the cover plate 192 and the lower plate 182, in which the board 14 is disposed.

The rear cover 196 may be divided into a plurality of parts. That is, a plurality of rear covers 196 may be provided. For example, the rear covers 196 may not be provided under the extension plates 193. That is, when viewed in plan, the rear covers 196 and the extension plates 193 may not overlap each other. For example, the pair of extension plates 193 may be located between a pair of rear covers 196.

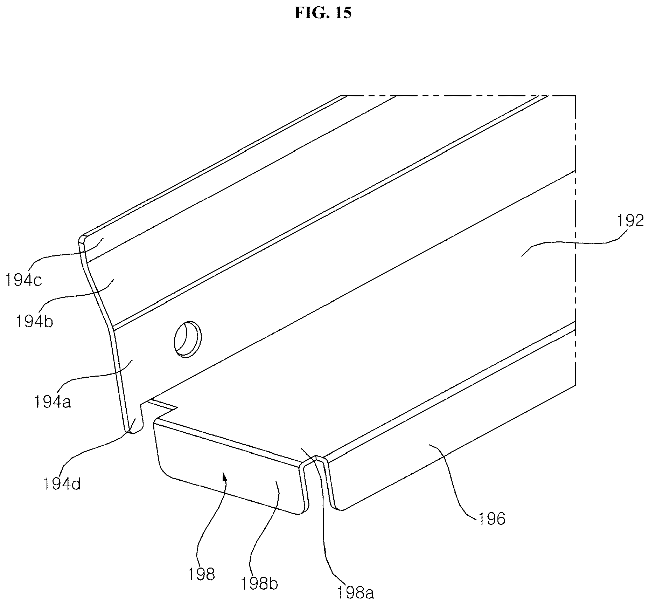

Referring to FIGs. 14 and 15, the front cover 194 may include a vertical portion 194a bent and extending upward from the cover plate 192, an inclined portion 194b bent and extending obliquely from the vertical portion 194a, and a flange portion 194c bent and extending upward from the inclined portion 194b. The vertical portion 194a, the inclined portion 194b, and the flange portion 194c may be sequentially located from below to above. The vertical portion 194a, the inclined portion 194b, and the flange portion 194c may be integrated with each other.

The front cover 194 may be elongated along the lower side of the display panel 11. The cover plate 192 may be elongated along the lower side of the display panel 11. The front cover 194 may have a greater length than the cover plate 192. For example, the front cover 194 may protrude in the leftward-rightward direction beyond the cover plate 192.

The vertical portion 194a may correspond to a vertical plate connected to the cover plate 192. For example, the vertical portion 194a may extend vertically in the upward direction from the front end of the cover plate 192. The vertical portion 194a may correspond to the guide surface 184g of the guide wall 184 of the lower frame 18. The vertical portion 194a and the cover plate 192 may form an angle. For example, the vertical portion 194a and the cover plate 192 may form an angle of about 90 degrees.

The inclined portion 194b may extend obliquely from the upper end of the vertical portion 194a. The inclined portion 194b may be bent from the vertical portion 194a. The inclined portion 194b may form an angle with the vertical portion 194a. For example, the inclined portion 194b may extend obliquely upward and forward from the upper end of the vertical portion 194a, and may form an obtuse angle with the vertical portion 194a.

The flange portion 194c may extend upward from the upper end of the inclined portion 194b. The flange portion 194c may correspond to a vertical plate connected to the upper end of the inclined portion 194b. The flange portion 194c may be parallel to the vertical portion 194a. The flange portion 194c may be located farther forward than the vertical portion 194a.

The inclined portion 194b may have a smaller width than the vertical portion 194a. The inclined portion 194b may have a smaller width than the flange portion 194c.

The front cover 194 may further include a guide protrusion 194d extending from the vertical portion 194a. The guide protrusion 194d may extend downward from the vertical portion 194a. The vertical portion 194a may be elongated along the lower side of the display 10, and the guide protrusion 194d may be located at one end and/or the other end of the vertical portion 194a in the longitudinal direction. For example, the vertical portion 194a may protrude in the leftward-rightward direction beyond the cover plate 192, and the guide protrusion 194d may extend downward from each of the left end and the right end of the vertical portion 194a that protrude beyond the cover plate 192.

The side cover 198 may extend from the cover plate 192. For example, the side cover 198 may extend from one end and/or the other end of the cover plate 192 in the longitudinal direction. The side cover 198 may include a horizontal portion 198a extending from one end of the cover plate 192 in the longitudinal direction and a vertical portion 198b bent and extending from the horizontal portion 198a. The horizontal portion 198a may extend horizontally from one end of the cover plate 192 in the longitudinal direction. The vertical portion 198b may be bent from the horizontal portion 198a. The vertical portion 198b may extend downward. The vertical portion 198b may be spaced apart from the rear cover 196 in the longitudinal direction of the cover plate 192. The guide protrusion 194d may be located in front of the side cover 198.

Referring to FIGs. 11, 16, and 17, the board cover 19 may include at least one coupling flange 197 extending from the rear cover 196. The coupling flange 197 may be bent from the rear cover 196. For example, the coupling flange 197 may be bent and extend forward from the lower end of the rear cover 196.

The coupling flange 197 may be provided in plural. The coupling flanges 197 may extend from the rear cover 196 and may be spaced apart from each other. The coupling flanges 197 may be arranged in the longitudinal direction of the cover plate 192.

The coupling flanges 197 may be coupled to the insertion portions 188s of the lower frame 18. For example, the coupling flanges 197 may be disposed in the insertion portions 188s defined between the rear bases 188, and the board cover 19 may be coupled to the lower frame 18. The coupling structure between the coupling flanges 197 and the insertion portions 188s may guide coupling of the board cover 19 and the lower frame 18. For example, the coupling structure between the coupling flanges 197 and the insertion portions 188s may guide the coupling position of the board cover 19 and the lower frame 18 in the horizontal direction.

The extension plates 193 of the board cover 19 may correspond to the recesses 189 in the lower frame 18. The extension plates 193 and the recesses 189 may be aligned in the forward-backward direction. Accordingly, cables (not shown) connected to the board 14 may be disposed in the recesses 189 in the lower frame 18, and the extension plates 193 may protect the cables (not shown) from above. In one embodiment, the cables (not shown) disposed in the recesses 189 may be coupled and fixed to the lower surfaces of the extension plates 193.

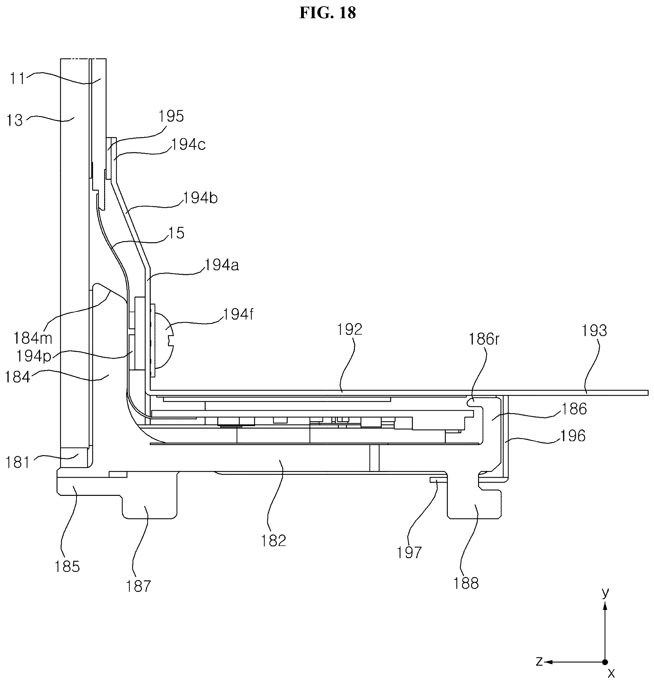

Referring to FIG. 18, the board cover 19 may be coupled to the lower frame 18. The board cover 19 may cover the board 14 disposed on the lower plate 182. The rear cover 196 may cover the space between the cover plate 192 and the lower plate 182, in which the board 14 is disposed, from the back. The coupling flange 197 may be disposed between the rear bases 188 and may fix the board cover 19 in upward-downward direction.

The vertical portion 194a may be coupled to the guide wall 184. Another portion of the connection film 15 may be disposed between the vertical portion 194a of the front cover 194 and the guide surface 184g of the guide wall 184.

The vertical portion 194a may further include a fastening port 194p through which a fastening member 194f passes. The fastening member 194f may pass through the fastening port 194p to be fixed to the guide wall 184, and the board cover 19 may be coupled to the lower frame 18.

The inclined portion 194b of the front cover 194 may cover the remaining portion of the connection film 15. The remaining portion of the connection film 15 may be located between the inclined portion 194b of the front cover 194 and the transparent panel 13.

The flange portion 194c of the front cover 194 may be coupled to the display panel 11. The flange portion 194c may be disposed at a lower end portion of the display panel 11. For example, the flange portion 194c may be coupled to a lower end portion of the lower surface of the display panel 11. A spacer pad 195 may be provided between the flange portion 194c and the display panel 11. The flange portion 194c may be coupled to the display panel 11 via the spacer pad 195.

Accordingly, the board cover 19 may protect the board 14 from external foreign substances or liquid.

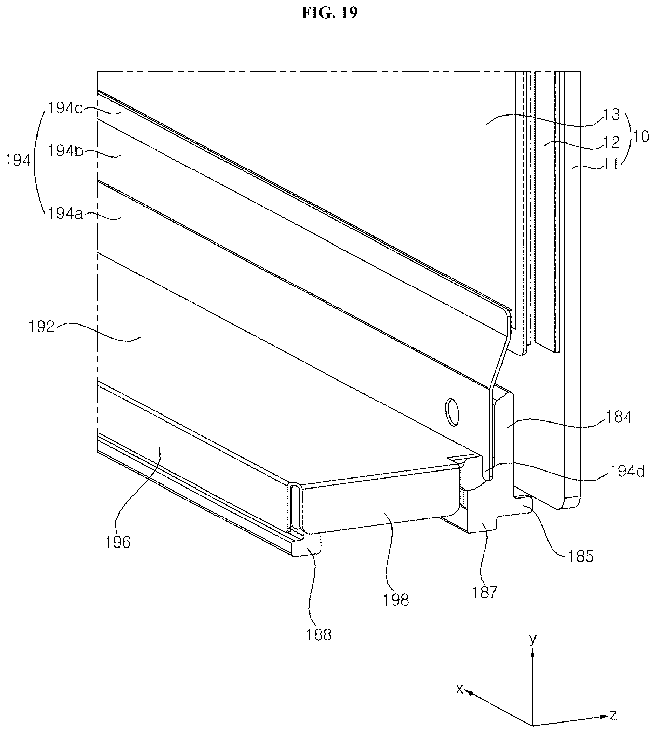

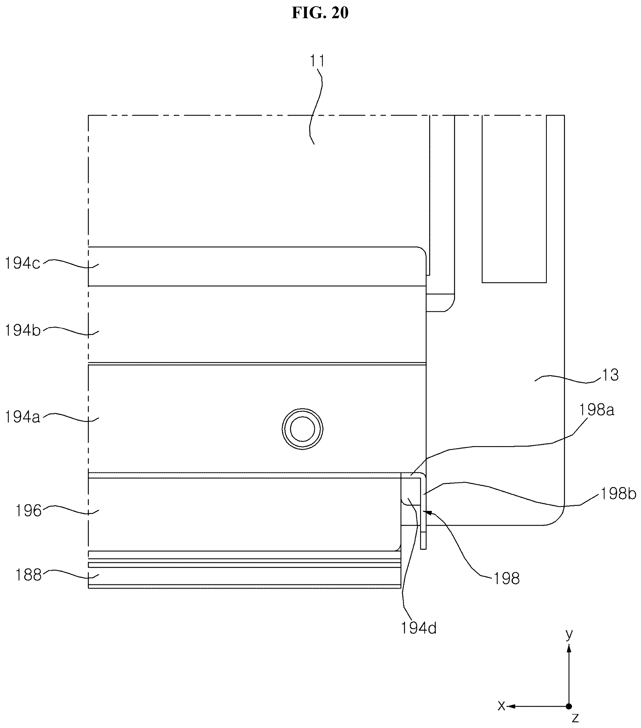

Referring to FIGs. 19 and 20, the board cover 19 may cover the upper surface and the side surface of the board 14. The cover plate 192 may cover the upper surface of the board 14. The side cover 198 may cover the side surface of the board 14. The rear cover 196 may cover the rear end of the board 14. The front cover 194 may cover the guide wall 184 and the connection film 15. The front cover 194 may cover the connection film 15 and the lower end of the display panel 11.

Accordingly, the board cover 19 may protect the board 14 and the connection film 15 from liquid entering the display device 1. For example, liquid on the front cover 194 may flow along the front cover 194 to the cover plate 192 and may flow down along the side covers 198 and the rear cover 196 without contacting the board 14.

In particular, because the side cover 198 and the rear cover 196 are located farther outward than the edge of the lower frame 18 when viewed in plan, liquid flowing down along the side cover 198 and the rear cover 196 may not contact the lower frame 18. The liquid flowing down along the side cover 198 and the rear cover 196 may directly move down to a level lower than the board 14.

In addition, a portion of the liquid flowing down along the front cover 194 may flow down along the guide protrusion 194d. The guide protrusion 194d may allow the liquid on the front cover 194 to be drained directly. That is, the guide protrusion 194d may guide the liquid to be drained.

Because a portion (e.g., the open hole 183a) of the lower frame 18 adjacent to the guide protrusion 194d is cut out, the liquid flowing along the guide protrusion 194d may be less likely to reach the lower frame 18.

Accordingly, the liquid on the front cover 194 may fall directly along the guide protrusion 194d, and an amount of liquid flowing toward the lower plate 182 may be reduced.

In addition, a risk of the board 14 being exposed to the liquid may be reduced.

Because the side cover 198 protrudes in the leftward-rightward direction beyond the cover plate 192, liquid flowing along the side cover 198 may fall without contacting the lateral end of the lower frame 18. The vertical portion 198b of the side cover 198 may be aligned with the lateral end of the front cover 194. For example, the horizontal position of the vertical portion 198b of the side cover 198 and the horizontal position of the lateral end of the front cover 194 may be substantially the same.

Accordingly, a risk of the board 14 disposed on the lower frame 18 being exposed to liquid may be reduced.

The lower plate 182 may be spaced apart from the floor or bottom surface through the rear base 188 and the front base 187, and may thus be spaced upward from liquid accumulated on the floor or bottom surface.

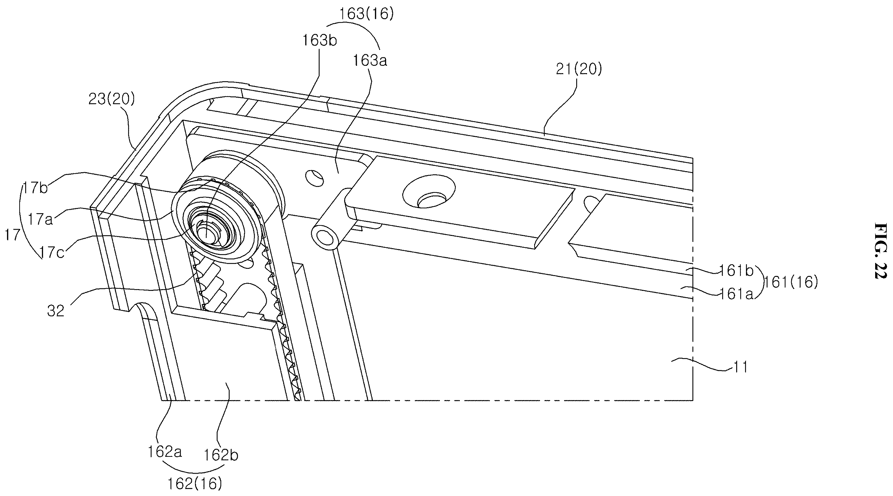

Referring to FIGs. 21 and 22, the display panel 11 may be disposed on a rear surface of the transparent panel 13. The display panel 11 may be attached or fixed to the adhesive film 12.

A frame fixing member 16 may include a horizontal fixing member 161, a vertical fixing member 162, and a corner fixing member 163. The horizontal fixing member 161 may be integrally formed with the vertical fixing member 162. The horizontal fixing member 161 and the vertical fixing member 162 may be referred to as inner frames 161 and 162. The horizontal fixing member 161 may include a plate 161a and a wall 161b. The plate 161a may be elongated in the leftward-rightward direction and may be fixed to the first part 21 of the side frame 20. The wall 161b may be formed on the plate 161a. The wall 161b may protrude backward from an outer surface of the plate 161a.

The vertical fixing member 162 may include a plate 162a and a wall 162b. The plate 162a may be elongated in the upward-downward direction and may be fixed to the third part 23 of the side frame 20. The wall 162b may be formed on the plate 162a. The wall 162b may protrude in the leftward-rightward direction from an outer surface of the plate 162a.

The corner fixing member 163 may be a bent plate segment. The corner fixing member 163 may be a plate 163a bent along a corner between the vertical fixing member 162 and the horizontal fixing member 161. A pulley shaft 163b may protrude and extend from an outer surface of the plate 163a of the corner fixing member 163 toward a rear side of the transparent panel 13. The corner fixing member 163 may be attached or fixed to the horizontal fixing member 161 and/or to the vertical fixing member 162. The corner fixing member 163 may be referred to as a left corner fixing member 163 or a first corner fixing member 163. When the corner fixing member 163 is located at a corner defined by the first part 21 and the second part 22 of the side frame 20 (see FIG. 5), the corner fixing member 163 may be referred to as a right corner fixing member 163 or a second corner fixing member 163.

The pulley 17 may be fitted on the pulley shaft 163b. The pulley 17 may rotate on the pulley shaft 163b. The pulley 17 may be referred to as an upper pulley 17. For example, a lubricant for noise prevention may be applied between the pulley shaft 163b and the pulley 17. In another example, the pulley 17 may be formed of synthetic resin having low frictional resistance, and the pulley shaft 163b may include metal to prevent noise and allow smooth rotation of the pulley 17. A belt 32 may be wound around the pulley 17.

The pulley 17 may include a wheel 17a and a belt gear 17b. The wheel 17a may be formed in a ring or rim shape. The pulley shaft 163b may be inserted into the wheel 17a, and the wheel 17a may rotate on the pulley shaft 163b. The belt gear 17b may define an outer circumferential surface of the wheel 17a. A fixing washer 17c may be coupled to the pulley shaft 163b at a position adjacent to an end of the pulley shaft 163b. For example, the fixing washer 17c may be an E-ring. The fixing washer 17c may prevent separation of the pulley 17 from the pulley shaft 163b. The first pulley 17 or the left pulley 17 may be located on the first corner fixing member 163 or the left corner fixing member 163, and the second pulley 17 (see FIG. 5) or the right pulley 17 (see FIG. 5) may be located on the second corner fixing member 163 or the right corner fixing member 163.

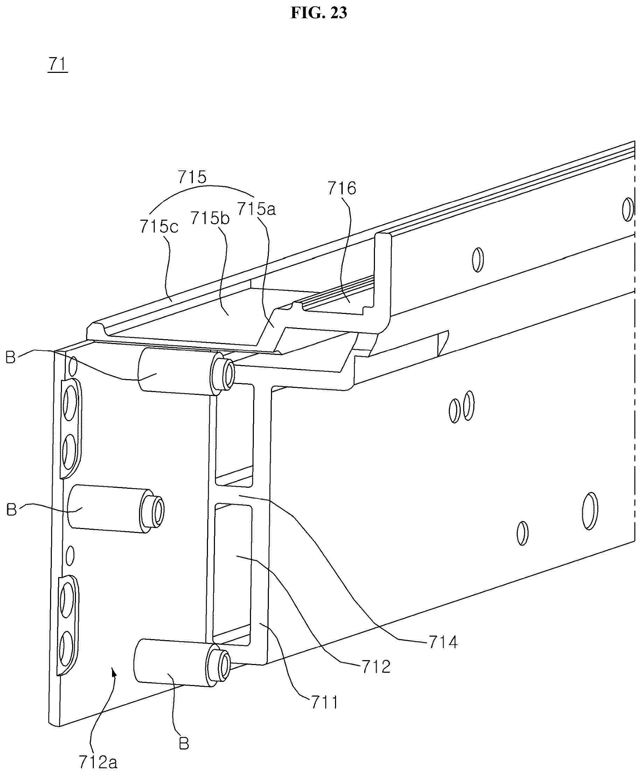

Referring to FIG. 23, the housing frame 71 may include a front part 712, a rear part 711, an inner rib 714, a bar support 715, and a top part 716. The front part 712 may face the rear part 711. The rear part 711 may be opposite the front part 712. The inner rib 714 may be formed between the front part 712 and the rear part 711 to interconnect the front part 712 and the rear part 711. A gap or a space may be defined between the front part 712 and the rear part 711 by the inner rib 714.

The bar support 715 may include a back support 715a, a bottom support 715b, and a front support 715c. For example, the bar support 715 may be generally L-shaped. The front support 715c may be located opposite the back support 715a with respect to the bottom support 715b. The front support 715c and/or the back support 715a may define a wall with respect to the bottom support 715b. The back support 715a may have a greater height than the front support 715c. The top part 716 may be connected to the back support 715a.

A mounting part 712a may be defined by a portion of the front part 712 that is exposed as the rear part 711 is cut out. When the rear part 711 and/or the inner rib 714 is cut out, a rear surface of a portion of the front part 712 may be exposed. Bosses B may be fixed to the mounting part 712a.

Accordingly, torsional and/or bending rigidity of the housing frame 71 may be increased.

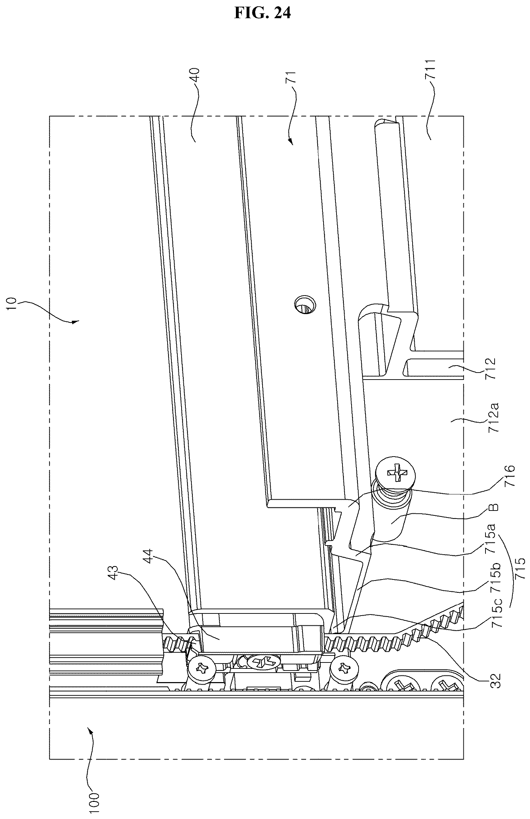

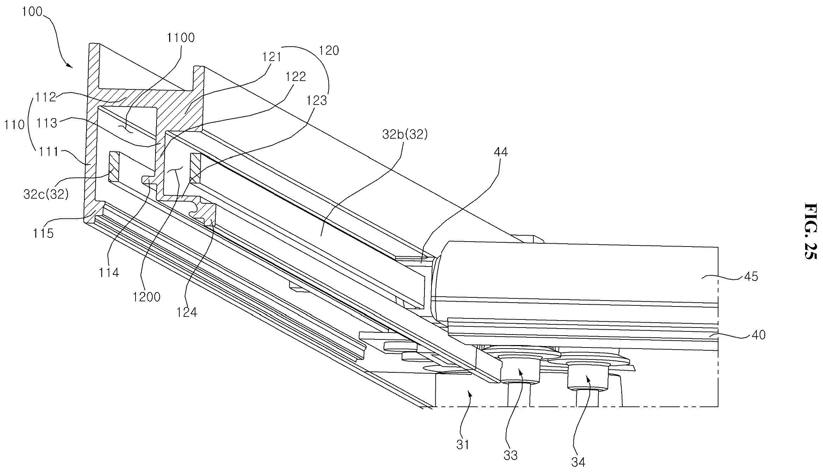

Referring to FIGs. 24 and 25, a light-shielding film 45 may cover the front part 712 of the housing frame 71. The light-shielding film 45 may be coupled or fixed to the bar 40. The bar 40 may be located on the bar support 715. When the bar 40 is located on the bar support 715, the bar 40 may be located at a bottom dead point.

The display 10 may be located opposite the housing frame 71 with respect to the light-shielding film 45. The display 10 may face the light-shielding film 45 and/or the front part 712 of the housing frame 71. The bar 40 may be located adjacent to the rear surface of the display 10.

The belt 32 may be coupled or fixed to one end of the bar 40. A fixing assembly 43 and 44 may secure the belt 32 to one end of the bar 40. The fixing assembly 43 and 44 may include a fixing bracket 44 and a belt fixing member 43. The fixing bracket 44 may be fixed to one end of the bar 40. The belt 32 may be located between the fixing bracket 44 and the belt fixing member 43. The belt fixing member 43 may secure the belt 32 to the fixing bracket 44.

A middle frame 100 may be another embodiment of the above-described frame fixing member 16 (see FIG. 22). For example, the middle frame 100 may be a part in which the above-described side frame 20 (see FIG. 22) and the above-described frame fixing member 16 (see FIG. 22) are formed integrally as a single piece. In another example, the middle frame 100 may be another embodiment of the above-described side frame 20 (see FIG. 22).

The middle frame 100 may include an outer part 110 and an inner part 120. The outer part 110 may have a U-beam shape elongated to accommodate a belt 32c. The outer part 110 may include a first part 111, a second part 112, and a third part 113. The first part 111 may be an elongated plate. The first part 111 may define an outer surface of the middle frame 100. The second part 112 may extend perpendicularly from the first part 111 and may be connected to the third part 113. The third part 113 may face the first part 111 and may be connected to the second part 112. An inner guide rib 114 may protrude from the third part 113 to face the first part 111 and may be spaced apart from the first part 111. The belt 32c may be located in a space defined by the first part 111, the second part 112, and/or the third part 113. The belt 32c may be referred to as an outer belt 32c.

The inner part 120 may have a U-beam shape elongated to accommodate a belt 32b. The inner part 120 may include a first part 121, a second part 122, and a third part 123. The first part 121 may extend from the second part 112 of the outer part 110 and may form a plate together with the second part 112 of the outer part 110. The second part 122 may extend perpendicularly from the first part 121 and may form the same plate as the third part 113 of the outer part 110. The second part 122 may be integrally formed with the third part 113 of the outer part 110. The third part 123 may extend perpendicularly from the second part 122 and may face the first part 121. The belt 32b may be located in a space defined by the first part 121, the second part 122, and/or the third part 123. The belt 32b may be referred to as an inner belt 32b.

The belt 32c located on the outer part 110 may be located opposite the belt 32b located on the inner part 120 with respect to the third part 113 of the outer part 110 and/or the second part 122 of the inner part 120. The fixing bracket 44 may be inserted into the inner part 120. The fixing bracket 44 may be located between the first part 121 and the third part 123 of the inner part 120.

A first coupling rib 115 may be formed on an inner surface of the first part 111 of the outer part 110. A second coupling rib 124 may be formed on an outer surface of the third part 123 of the inner part 120. The second coupling rib 124 may face the first coupling rib 115.

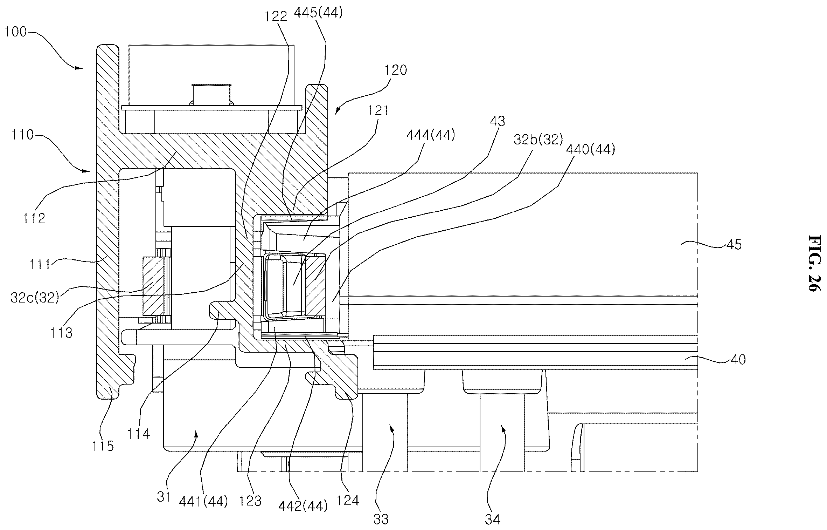

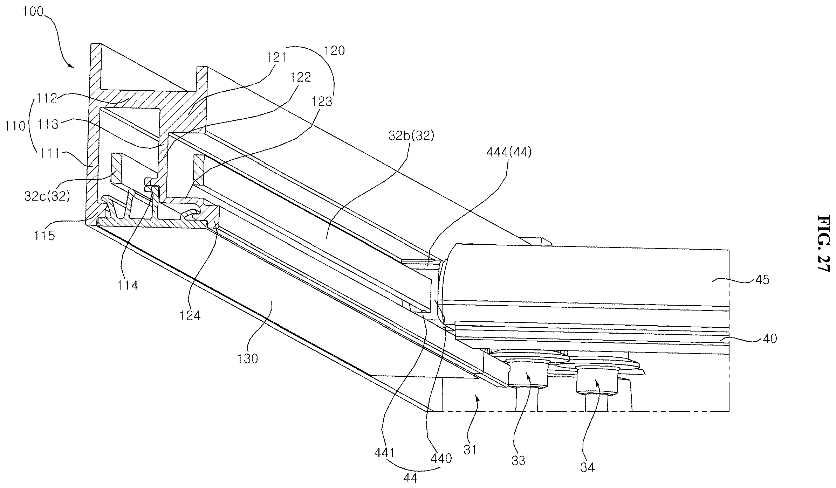

Referring to FIGs. 26 and 27, the fixing assembly 43 and 44 may be inserted between the first part 121 and the third part 123 of the inner part 120 of the middle frame 100. A bracket base 440 of the fixing bracket 44 may be fixed to one end of the bar 40.

A first side wall 441 of the fixing bracket 44 may be supported by the third part 123 of the inner part 120 of the middle frame 100. A first support rib 442 formed on the first side wall 441 of the fixing bracket 44 may be in contact with or slide along the third part 123 of the inner part 120.

A second side wall 444 of the fixing bracket 44 may be supported by the first part 121 of the inner part 120 of the middle frame 100. A second support rib 445 formed on the second side wall 444 of the fixing bracket 44 may be in contact with or slide along the first part 121 of the inner part 120.

The first side wall 441 and/or the second side wall 444 may be supported by or spaced apart from the second part 122 of the inner part 120 of the middle frame 100. The first side wall 441 and/or the third side wall 443 may be supported by or spaced apart from the second part 122 of the inner part 120 of the middle frame 100. A gap may be defined between the side walls 441, 443, and 444 and the second part 122 of the inner part 120 of the middle frame 100. A lubricant may be applied between the fixing bracket 44 and the inner part 120 of the middle frame 100.

The frame cover 130 may be coupled to the first coupling rib 115 of the outer part 110 and/or to the second coupling rib 124 of the inner part 120. The frame cover 130 may define one surface of the middle frame 100.

Accordingly, both ends of the bar 40 may be maintained at the same horizontal level, and noise and/or vibration that may occur between the bar 40 and the middle frame 100 may be reduced.

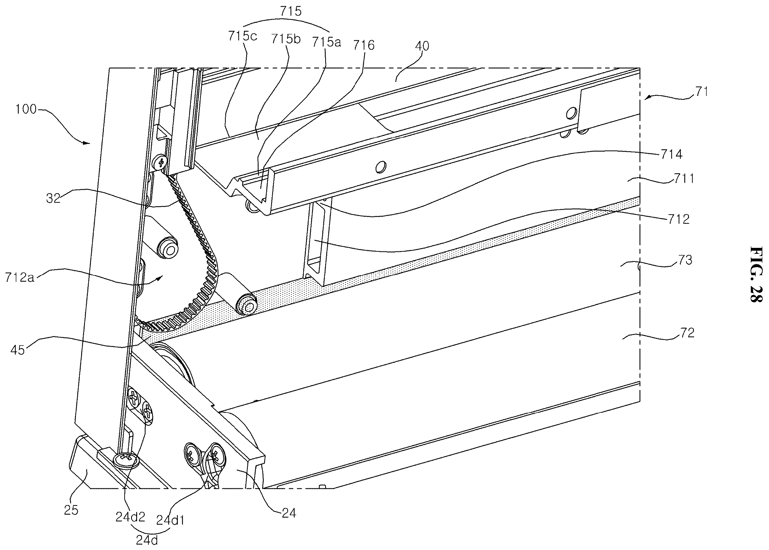

Referring to FIG. 28, the middle frame 100 may be coupled to the base frame 25. A roller bracket 24 may be coupled to the base frame 25 and/or to the middle frame 100. The roller bracket 24 may include a roller mount 24d. The roller mount 24d may be provided in plural. For example, a main roller mount 24d1 and a sub-roller mount 24d2 may be formed on the roller bracket 24. The sub-roller mount 24d2 may be adjacent to the main roller mount 24d1. The sub-roller mount 24d2 may be located between the main roller mount 24d1 and the housing frame 71.

A main roller 72 may be rotatably coupled to the main roller mount 24d1. The light-shielding film 45 may be wound around the main roller 72. The light-shielding film 45 wound around the main roller 72 may be unwound from or wound onto the main roller 72. A sub-roller 73 may support the light-shielding film 45. As the light-shielding film 45 is unwound from the main roller 72, the sub-roller 73 may guide the light-shielding film 45 toward the front surface of the housing frame 71.

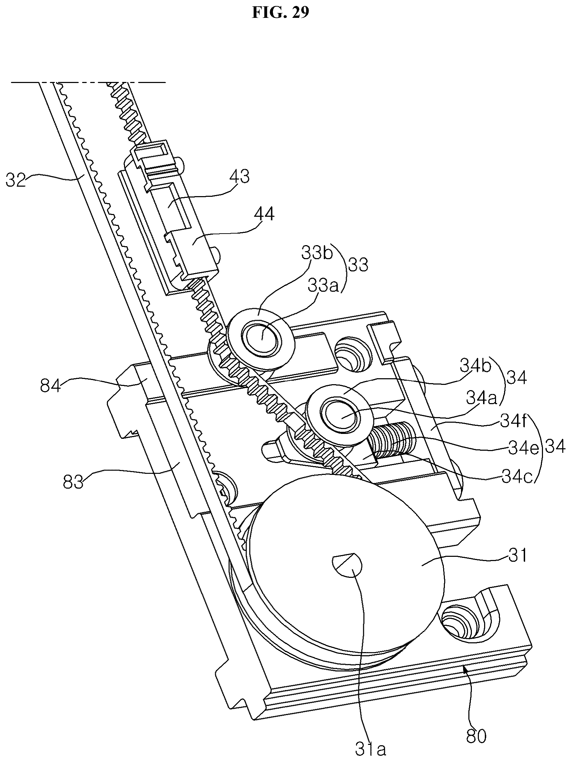

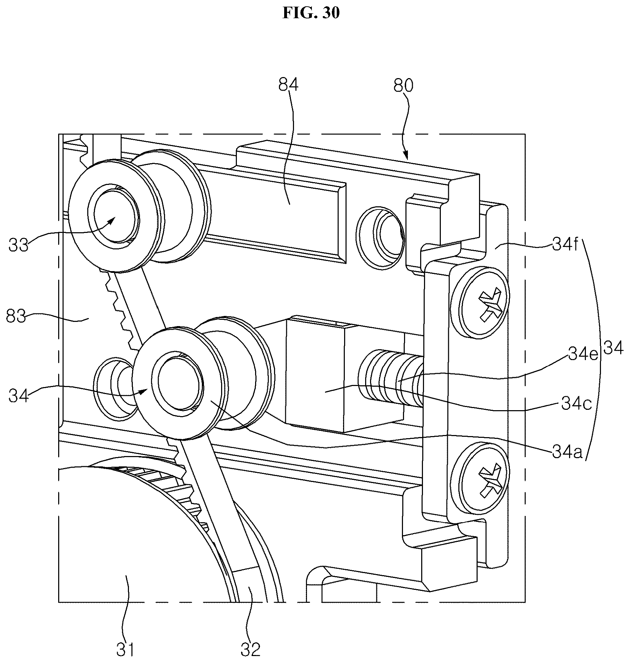

Referring to FIGs. 29 and 30, both ends of the belt 32 may be connected to each other by the fixing assembly 43 and 44. The fixing assembly 43 and 44 may secure the belt 32 to one end of the bar 40 (see FIG. 27). The belt 32 may be wound around a driving pulley 31. For example, the belt 32 may be a timing belt. The inner teeth of the belt 32 may be engaged with the teeth on the outer circumferential surface of the driving pulley 31. The outer surface of the belt 32 may be a smooth surface. A sub-pulley 33 may support the outer surface of the belt 32. A rotation shaft 33a of the sub-pulley 33 may be parallel to a rotation shaft 31a of the driving pulley 31. For example, a line interconnecting the rotational center of the sub-pulley 33 and the rotational center of the driving pulley 31 may be parallel to the upward-downward direction of the belt 32. The driving pulley 31 may have a larger diameter than a pulley 33b of the sub-pulley 33. Between the sub-pulley 33 and the driving pulley 31, a portion of the belt 32 may form an incline relative to an opposite portion of the belt 32.

A pulley 34b of a tension pulley 34 may be located between the sub-pulley 33 and the driving pulley 31. The pulley 34b of the tension pulley 34 may support the outer surface of the belt 32. The pulley 34b of the tension pulley 34 may push the outer surface of the belt 32. The tension of the belt 32 may be automatically adjusted by the force with which the pulley 34b of the tension pulley 34 pushes the outer surface of the belt 32. Accordingly, the tension of the belt 32 may be maintained at a constant level.

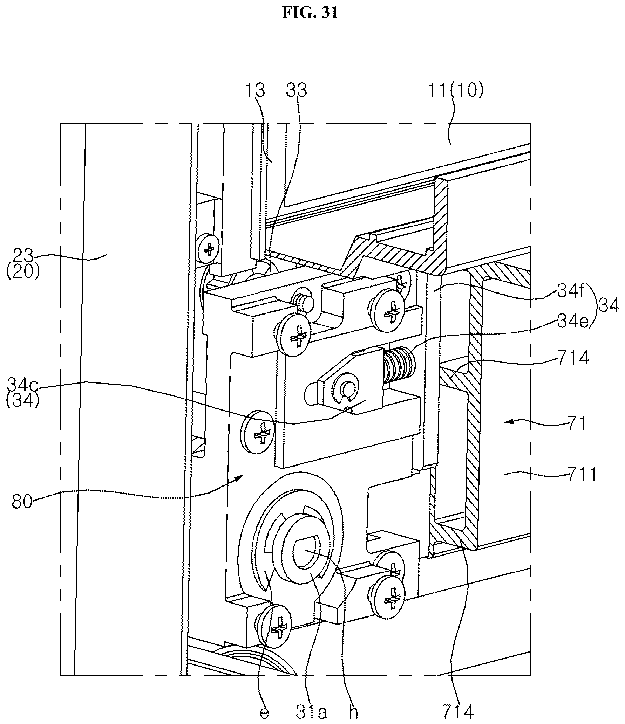

Referring to FIG. 31, a pulley block 80 may be coupled to the rear side of the housing frame 71. The pulley block 80 may be fixed to the rear surface of the housing frame 71. The pulley block 80 may be fixed to the mounting part 712a (see FIG. 23) of the housing frame 71.

The rotation shaft 31a of the driving pulley 31 (see FIG. 29) may be exposed from the rear surface of the pulley block 80 fixed to the mounting part 712a (see FIG. 23) of the housing frame 71. An E-ring e may be coupled to the rotation shaft 31a of the driving pulley 31. A power hole h may be formed in the rotation shaft 31a of the driving pulley 31.

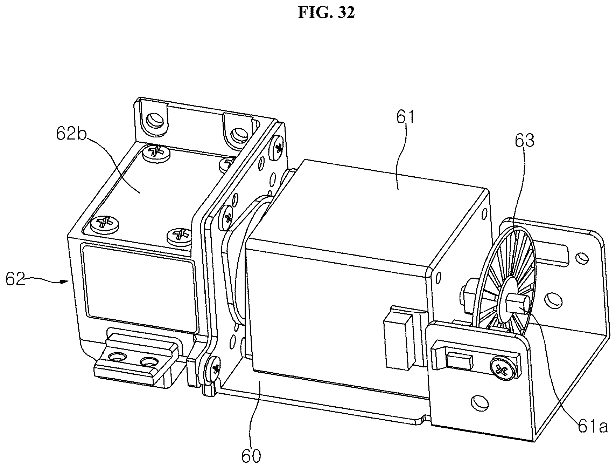

Referring to FIG. 32, a gearbox 62 may be located adjacent to the motor 61 and may be coupled to the motor 61. A motor bracket 60 may be fixed to the gearbox 62. The motor 61 may be located on the motor bracket 60 and may be fixed to the motor bracket 60. The motor 61 may be connected to the gearbox 62. A rotation counter 63 may be fixed to one end of a motor shaft 61a so as to rotate together with the motor shaft 61a. The gearbox 62 may be connected to the other end of the motor shaft 61a. The gearbox 62 may transmit rotational power provided from the motor 61 to the rotation shaft 31a (see FIG. 29) of the driving pulley 31 (see FIG. 29).

The gearbox 62 may have a rectangular box shape with one surface open. A box cover 62b may cover an opening defined by the open surface of the gearbox 62. The box cover 62b may be fixed to the opening of the gearbox 62.

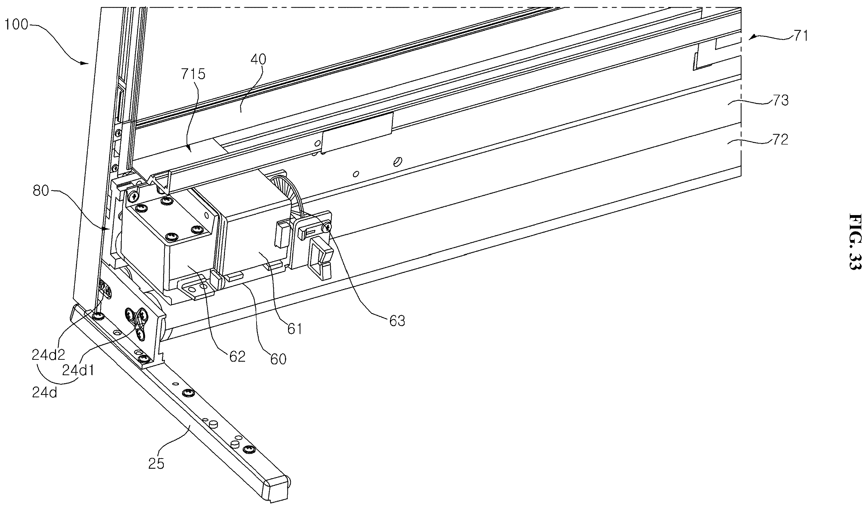

Referring to FIGs. 29 and 33, when rotational power is provided from the motor 61, the driving pulley 31 may rotate through the gearbox 62. When the driving pulley 31 rotates, the belt 32 may move, and the bar 40 fixed to the belt 32 by the fixing assembly 43 and 44 may move upward and downward along the middle frame 100.

When the bar 40 moves upward along the middle frame 100, the light-shielding film 45 (see FIG. 27) having one end fixed to the bar 40 may move together with the bar 40. When the bar 40 moves, the light-shielding film 45 (see FIG. 27) wound around the main roller 72 may be unwound, and the light-shielding film 45 (see FIG. 27) may move upward along the middle frame 100.

When the bar 40 moves downward along the middle frame 100, the main roller 72 may wind the light-shielding film 45 (see FIG. 27). As the light-shielding film 45 is wound onto the main roller 72, the light-shielding film 45 (see FIG. 27) may move downward along the middle frame 100.

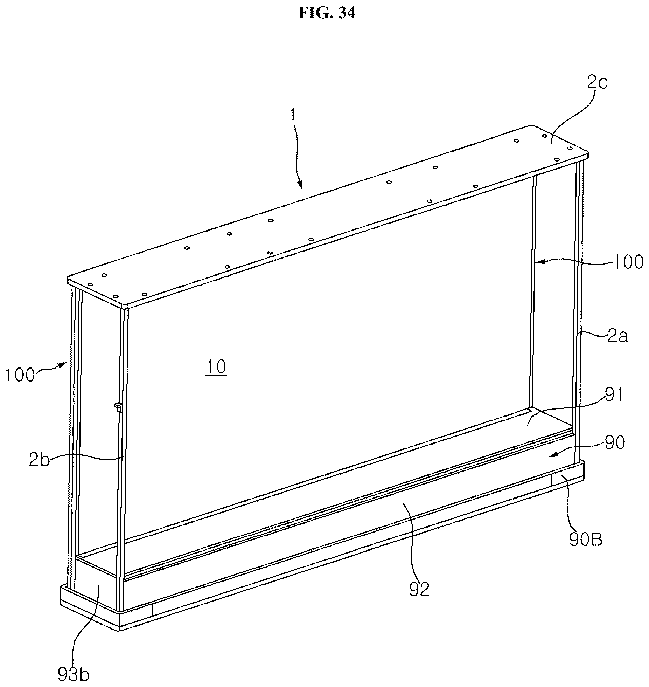

Referring to FIG. 34, the display device 1 may include a middle frame 100, rear frames 2a and 2b, a top roof 2c, a housing 90, and a bottom base 200. The bottom base 200 may be located at a lower portion of the display device 1 and may define a bottom of the display device 1. The housing 90 may be located on the bottom base 200. The middle frame 100 may be coupled or fixed to the bottom base 200. The top roof 2c may be coupled or fixed to an upper end of the middle frame 100.

The first rear frame 2a may be located parallel to the middle frame 100 and may be coupled to the top roof 2c and the housing 90. The second rear frame 2b may be located parallel to the middle frame 100 and may be coupled to the top roof 2c and the housing 90.

The housing 90 may be a rectangular box elongated along the second long side LS2 (see FIG. 1) of the display 10. The housing 90 may include a top plate 91, a rear plate 92, and side plates 93b. The top plate 91 may be a plate that is located at a rear side of the display 10 and is disposed in the thickness direction of the display 10.

Referring to FIGs. 1 to 34, a display device 1 may include a display panel 11 that is configured to display an image on a surface thereof and is light-transmissive and a board 14 electrically connected to the display panel 11. The board 14 may not overlap the display panel 11 in a first direction perpendicular to the surface of the display panel 11.

The display device may further include a transparent panel 13 facing the display panel 11.

The transparent panel 13 may include a first region RE1 overlapping the display panel 11 in the first direction and a second region RE2 not overlapping the display panel 11 in the first direction.

The board 14 may overlap the second region RE2 of the transparent panel 13 in the first direction.

The board 14 may extend in a second direction passing through the surface of the display panel 11.

The board 14 may extend in the first direction.

The display device may further include a transparent panel 13 facing the display panel 11 and extending downward beyond the display panel 11 and a lower frame 18 provided below the display panel 11 and configured to support the transparent panel 13.

The lower frame 18 may include a lower plate 182 located adjacent to a lower side of the display panel 11 and extending along the lower side of the display panel 11.

The board 14 may be provided on the lower plate 182.

The lower frame 18 may further include a support rib 185 extending along a lower side of the transparent panel 13 and configured to support the transparent panel 13.

The lower frame 18 may further include a guide wall 184 provided below the display panel 11 and configured to support a surface of the transparent panel 13.

The guide wall 184 may have an upper end spaced apart from a lower end of the display panel 11.

The display device may further include a connection film 15 interconnecting the lower side of the display panel 11 and the board 14.

The guide wall 184 may include a concave surface 184c facing the connection film 15 and extending concavely from a surface of the lower plate 182 in an upward direction.

The board 14 may be disposed on the surface of the lower plate 182.

The guide wall 184 may further include a guide surface 184g extending upward from the concave surface 184c and facing the connection film 15.

The guide wall 184 may further include an inclined surface 184m extending obliquely from an upper end of the guide surface 184g of the guide wall 184 and facing the connection film 15.

The inclined surface 184m may extend upward toward the transparent panel 13.

The guide wall 184 may further include a convex surface 184v located between the guide surface 184g and the inclined surface 184m and extending convexly.

The lower frame 18 may further include a holder 186 located opposite the guide wall 184 with respect to the lower plate 182 and extending upward from an edge of the lower plate 182.

The board 14 may be fixed to the holder 186.

The holder 186 may include a holder rib 186r extending from an upper end of the holder 186 toward the guide wall 184.

The board 14 may have an end located between the holder rib 186r and the lower plate 182.

As is apparent from the above description, the present disclosure has the following effects.

According to at least one of embodiments of the present disclosure, a display device having improved performance may be provided.

According to at least one of embodiments of the present disclosure, a display device in which a transparent region of a transparent display panel is maximized may be provided.

According to at least one of embodiments of the present disclosure, a compact display device may be provided.

According to at least one of embodiments of the present disclosure, a display device having improved drainage performance may be provided.

According to at least one of embodiments of the present disclosure, a display device having enhanced structural stability may be provided.

According to at least one of embodiments of the present disclosure, a display device capable of minimizing damage applied to electric components may be provided.

According to at least one of embodiments of the present disclosure, an efficient arrangement structure of electric components may be provided.

The additional scope of applicability of the present disclosure is apparent from the above detailed description. However, those skilled in the art will appreciate that various modifications and alterations are possible, without departing from the idea and scope of the present disclosure, and therefore it should be understood that the detailed description and specific embodiments, such as the preferred embodiments of the present disclosure, are provided only for illustration.

Certain embodiments or other embodiments of the disclosure described above are not mutually exclusive or distinct from each other. Any or all elements of the embodiments of the disclosure described above may be combined with each other in configuration or function.

For example, a configuration "A" described in one embodiment of the disclosure and/or the drawings and a configuration "B" described in another embodiment of the disclosure and/or the drawings may be combined with each other. Namely, although the combination between the configurations is not directly described, the combination is possible except in the case where it is described that the combination is impossible.

The above detailed description is not intended to be construed to limit the disclosure in all aspects and to be considered by way of example. The scope of the disclosure should be determined by reasonable interpretation of the appended claims and all equivalent modifications made without departing from the disclosure should be included in the following claims.

## Claims

1. A display device (1) comprising:
a display panel (11) configured to display an image on a surface thereof, the display panel (11) being light-transmissive; and
a board (14) electrically connected to the display panel (11),
wherein the board (14) does not overlap the display panel (11) in a first direction perpendicular to the surface of the display panel (11).

2. The display device (1) according to claim 1, further comprising a transparent panel (13) facing the display panel (11),
wherein the transparent panel (13) comprises a first region (RE1) overlapping the display panel (11) in the first direction and a second region (RE2) not overlapping the display panel (11) in the first direction, and
wherein the board (14) overlaps the second region (RE2) of the transparent panel (13) in the first direction.

3. The display device (1) according to claim 1 or 2, wherein the board (14) extends in a second direction passing through the surface of the display panel (11).

4. The display device (1) according to any one of claims 1 to 3, wherein the board (14) extends in the first direction.

5. The display device (1) according to claim 1, further comprising:
a transparent panel (13) facing the display panel (11) and extending downward beyond the display panel (11); and
a lower frame (18) provided below the display panel (11), the lower frame (18) being configured to support the transparent panel (13).

6. The display device (1) according to claim 5, wherein the lower frame (18) comprises a lower plate (182) located adjacent to a lower side of the display panel (11) and extending along the lower side of the display panel (11), and
wherein the board (14) is provided on the lower plate (182).

7. The display device (1) according to claim 6, wherein the lower frame (18) further comprises a support rib (185) extending along a lower side of the transparent panel (13), the support rib (185) being configured to support the transparent panel (13).

8. The display device according to claim 6 or 7, wherein the lower frame (18) further comprises a guide wall (184) provided below the display panel (11), the guide wall (184) being configured to support a surface of the transparent panel (13), and
wherein the guide wall (184) has an upper end spaced apart from a lower end of the display panel (11).

9. The display device according to claim 8, further comprising a connection film (15) interconnecting the lower side of the display panel (11) and the board (14).

10. The display device (1) according to claim 9, wherein the guide wall (184) comprises a concave surface (184c) facing the connection film (15) and extending concavely from a surface of the lower plate (182) in an upward direction, and
wherein the board (14) is disposed on the surface of the lower plate (182).

11. The display device (1) according to claim 10, wherein the guide wall (184) further comprises a guide surface (184g) extending upward from the concave surface (184c) and facing the connection film (15).

12. The display device (1) according to claim 11, wherein the guide wall (184) further comprises an inclined surface (184m) extending obliquely from an upper end of the guide surface (184g) of the guide wall (184) and facing the connection film (15), and
wherein the inclined surface (184m) extends upward toward the transparent panel (13).

13. The display device (1) according to claim 12, wherein the guide wall (184) further comprises a convex surface (184v) located between the guide surface (184g) and the inclined surface (184m) and extending convexly.

14. The display device (1) according to one of claims 8 to 13, wherein the lower frame (18) further comprises a holder (186) located opposite the guide wall (184) with respect to the lower plate (182) and extending upward from an edge of the lower plate (182), and
wherein the board (14) is fixed to the holder (186).

15. The display device (1) according to claim 14, wherein the holder (186) comprises a holder rib (186r) extending from an upper end of the holder (186) toward the guide wall (184), and
wherein the board (14) has an end located between the holder rib (186r) and the lower plate (182).
